Europäisches Patentamt

(19) European Patent Office

Office européen des brevets

(11) Publication number: **0 035 885**
**A1**

(12) # EUROPEAN PATENT APPLICATION

(21) Application number: **81300943.8**

(22) Date of filing: **06.03.81**

(51) Int. Cl.³: **H 03 K 13/18**

(30) Priority: **10.03.80 US 128614**

(43) Date of publication of application:
**16.09.81 Bulletin 81/37**

(84) Designated Contracting States:
**CH DE FR GB IT LI**

(71) Applicant: **SPERRY CORPORATION**
**1290, Avenue of the Americas**
**New York, N.Y. 10019(US)**

(72) Inventor: **McMahon, Donald Howland**
**Judy Farm Road**
**Carlisle Massachusetts 01741(US)**

(74) Representative: **Michaels, Peter Albert**
**SPERRY UNIVAC Patent & Licensing Services M.S. S2**
**W1 SPERRY UNIVAC CENTRE**
**London NW10 8LS(GB)**

(54) Optical position sensor.

(57) An optical position sensor comprises a linear element or a disc (22) carrying stripes or rings coded with reflecting and non-reflecting areas. Light pulses of short duration from a source (12) are transmitted through a transmission line (15) coupled to optical fibres (20a to 20e) of differing lengths, whose ends (21a to 21e) are opposite the coded channels. When a reflecting area is opposite the fibre end, light is reflected back along the fibre and transmission line and returned to a light detector (25a) as a sequence of pulses. These pulses are applied to a shift register (26) from which they may be read in parallel form into a processor (31). A clock system (24) controls the light source and provides clocking pulses for the shift register, and, by means of a counter (29), a periodical pulse for resetting the shift register between the coded pulse sequences. A variable delay (27) permits the pulse sequences received at the shift register to be synchronised with the clock.

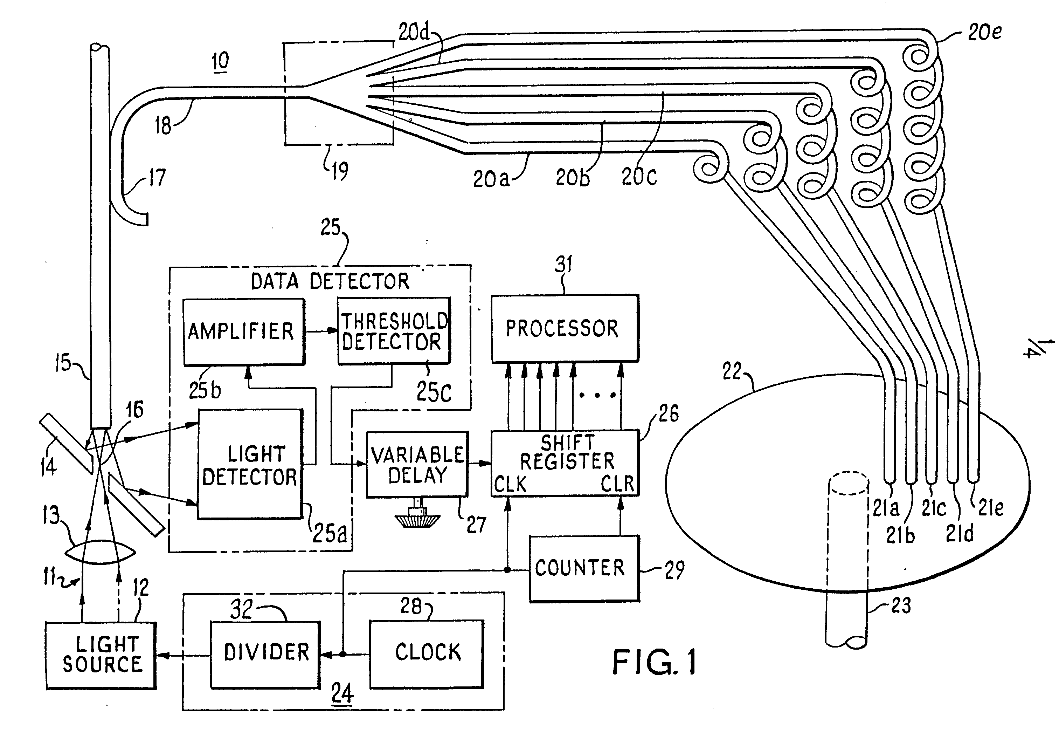

In a modification (not shown in Figure 1), the fibres may be coupled at sequential points along the transmission lines, and the transmission line may have a Y coupler to one arm of which the light source is coupled while the other serves for coupling the detector.

./...

FIG.1

-1-

## Optical Position Sensor

Position sensors are known for obtaining digital representation of angular rotation or linear displacement, and may comprise transducers containing a coded pattern of conducting and non-conducting areas. Brushes in contact with such a transducer generate a 'one' when in a conducting area and a 'zero' when in a non-conducting area. These devices require separate electrical circuits for each bit in a generated code. Positional sensitivity for these systems is a function of the number of bits in the code, which in turn is limited by the size of the brushes. Increased sensitivity may be provided by utilising a photoelectric encoder which comprises a disk with a multiplicity of concentric bands, or an element with a multiplicity of parallel bands arranged in a rectangular fashion, wherein each band is divided into transparent and opaque segments. A light source is positioned on one side of the disk, and photodetectors, or optical fibres leading to photodetectors, are arranged on the other, one photodetector, or optical fibre, for each band. When a transparent segment in a band is between the light source and the photodetector for that band, an electrical signal representative of a 'one' will appear at the output terminal of the photodetector, and when an opaque segment is between the light source and the photodetector, an electrical signal representative of a 'zero' will appear at the output terminal. This system requires as many detectors or optical fibre-detector combinations as there are bits in the coded signal. Both the electrical and optical systems require a multiplicity of data lines, as many as the number of data bits, to transmit the digital data to the processor. The present invention provides an optical analog-to-digital converter with which digital data may be transmitted along a single optic fibre in serial coded form, and in which the light source and detectors do not have to be in close proximity to the coded disc or channels.

The invention employs reflecting and non-reflecting coded areas in conjunction with a branched optical system in which the light paths are of different lengths, so that a single light pulse is reflected back to arrive at the beginning of the optical path as a sequence of pulses.

Consider optical fibres along which light propagates at a speed of $2 \times 10^8$ m/sec, each terminated with a reflecting device and each of a different length, with differential lengths that are substantially equal to 0.1 m. between successive light paths. Optical signals reflected from these devices may be resolved if an optical pulse with a $10^{-9}$ seconds duration (system bandwidth equal 1 GHz) is transmitted along the main fibre to each branch fibre. Optical signal resolution may be maintained, and the pulse width increased (system bandwidth decreased), if the differential line lengths are increased, as for example, a differential line length of one meter will require a pulse of substantially $10^{-8}$ seconds duration.

The invention will be further described, by way of example, with reference to the drawings; in which

Figure 1 is a schematic diagram of one embodiment of the invention.

Figure 2 is a diagram of a coded disc for angular position sensing.

Figure 3 is a block diagram of a time division demultiplexer.

Figure 4a is a diagram of a linear position code.

Figure 4b is a diagram showing fibre ends for use in conjunction with the code of Figure 4a to provide greater sensitivity.

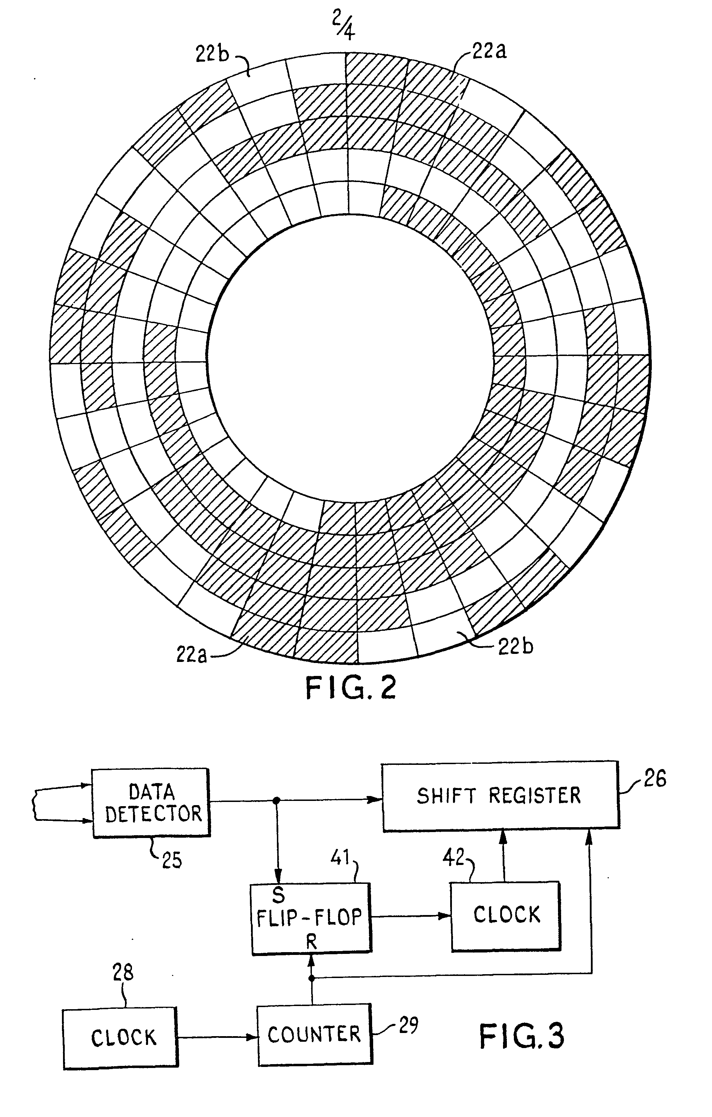

Referring first to Figure 1, a light pulse 11 from a source 12, which may be a LED or a laser, is focussed by a lens 13 through an aperture in a mirror 14 so as to strike the end of an optical fibre transmission line 15 having a numerical aperture corresponding to the divergence of the beam from the focus 16. A portion of the light passes from the optical transmission line 15 via an optical directional coupler to an optical fibre 18. The optical directional coupler 17 may be of the type disclosed by Hill et al in a letter entitled "Efficient Power Combiner For Multiplexing Sources to Single Fibre Optical Systems" in Applied Physics Letters, Vol. 31, December 1977. The remainder of the light pulse continues along the optical fibre 15 and is available for branch coupling via further couplers positioned at predetermined distances from the coupler 17. The fibre 18 is terminated with a transmitting star coupler 19, well known in the art, that distributes the pulsed optical energy between five optical fibres 20a through 20e. These five fibres, each of which has an end face of good optical quality perpendicular to the fibre axis, are of different lengths, for example, 2, 4, 6, 8, and 10 meters respectively. The end faces 21a through 21e are positioned in a row adjacent to and facing the surface of a binary coded disc 22. The binary code on the disc may be a Gray code and have patterns of reflecting areas 22a, and non-reflecting areas 22b, (see Fig. 2) arranged in concentric rings as shown in Figure 2, one end face 21a through 21e being opposite each of the binary coded rings of the disc. When a reflecting area 22a is opposite a fibre end the light pulse is reflected back through the fibre and when a non-reflecting area 22b is opposite the fibre end a relatively weak, or no, return optical signal is produced.

The source 12 is modulated by a modulator 24 to emit a sequence of light pulses, the duration of each of which is chosen with reference to the light velocity within the fibre and the desired time resolution. For fibres in which the velocity of light is $2 \times 10^8$ m/sec. and a resolution, corresponding to the 2-meter differences in the line lengths of the branch fibre 20a through 20e, the pulse repetition rate is of the order of 20 nanoseconds. The pulses from the source 12 pass through the optical system as described above and are either absorbed or reflected at the coding disc 22, dependent upon whether the end face is adjacent a reflecting area 22a or a non-reflecting area 22b. The reflected optical pulses pass back through the star coupler 19 to the transmission line 18 and through the directional

-4-

coupler 17 and transmission line 15, to the mirror 16 where they are reflected into a data detector 25. The reflected pulses are delayed by different times corresponding to their propagation times along the different paths comprising the fibres 21a to 21e. The detector 25 generates electrical pulses corresponding to the incident optical pulses. These pulses are applied to a shift register 26 in the sequence of arrival via a variable delay 27, the purpose of which will be explained below.

The modulator 24 includes a clock 28 that clocks a shift register 26, and, through a counter 29, provides a clear pulse for the shift register 26. The frequency of the clock 28 is the reciprocal of the desired time resolution, which for the example under consideration is 50 MHz, so that a clock pulse is supplied to the shift register 26 every 20 nanoseconds, permitting a continuous flow of data pulses from the data detector 25 into the shift register 26.

The data detector 25 comprises a light detector 25a illuminated by light pulses from the mirror 14 and supplies corresponding electrical pulses by way of an amplifier 25b to a threshold detector which compares the amplified electrical pulses to a fixed threshold level and provides a pulse of constant amplitude for each electrical pulse that exceeds the threshold, for coupling to the shift register 26. Since the time delay between the star coupler terminating the optical transmission line 18 and the incidence of the optical beam on the detector 25 may not be an integral multiple of a clock period, the data stream from the output of the detector 25 may not be in synchronism with the clock. This may be rectified by adjusting the variable delay 27.

The pulses from clock 28 are counted by counter 29 to provide a clearing pulse for the shift register 26 at the conclusion of each data stream, which, for the 5 bit system shown, would be after each fifth clock pulse, for example, at each sixth pulse counted. To avoid ambiguities, all the reflected pulses from each incident pulse from the source 12 must be received before the next pulse from the source 12 is applied to the optical transmission line 15, i.e. the interpulse period of the modulator 24 must be greater than the maximum return time of the last pulse in the data stream. This may be achieved by applying the pulses from the clock 28 to a divider 32 which provides the next source trigger pulse some time after the arrival of the last reflected pulse.

The position sensor described above is self-clocking, since the set of return pulses occur a fixed time after the transmitted light pulse from the source 12. Self-clocking may also be achieved by positioning the end face of the shortest optical fibre opposite a continuous reflecting band on the coded disc 22, thereby producing the first pulse return from the coded disc 22 for each transmitted pulse from the optical source 12. This first pulse may then be employed to initiate clocking of the shift register. Figure 3 shows a modification of the arrangement of Figure 1 arranged to operate in this way.

Referring now to this Figure, the electrical output signal of the detector 25 is applied to the shift register 26 and to an R-S flip-flop 41. At the inception of the first pulse from the detector 25 the set terminal of the flip-flop 41 supplies an enable signal to a clock 42, which thereupon commences to clock data into the shift register 26. As explained above, after all reflected pulses from each transmitted pulse have been received, the counter 29 provides a pulse to clear the shift register 26 and reset the flip-flop 41.

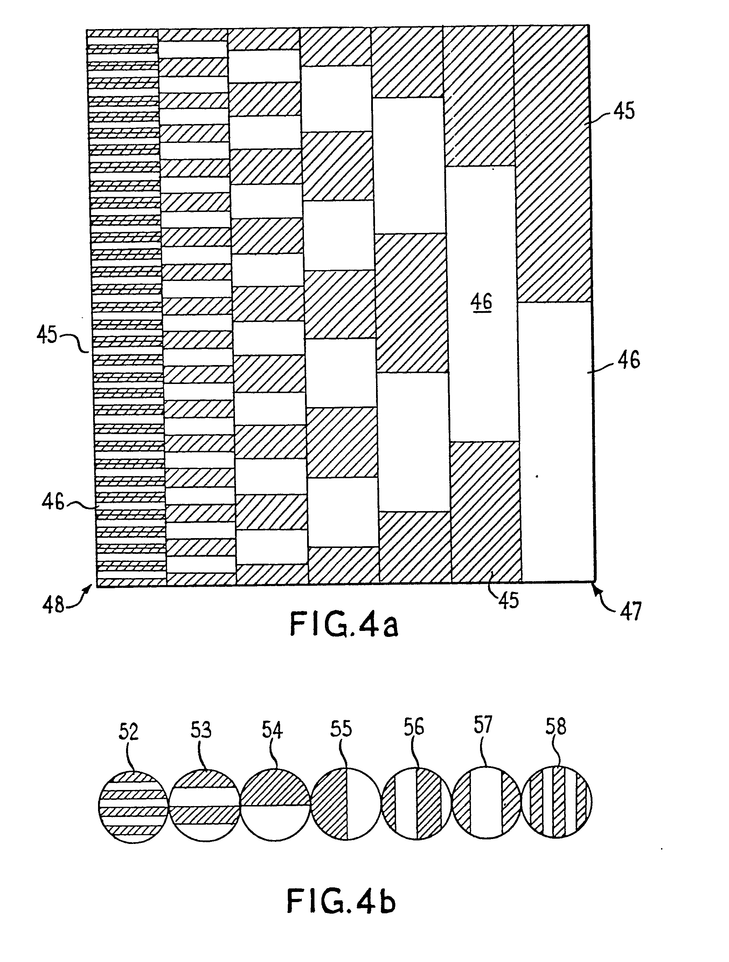

In place of the embodiment shown in Figure 1, a linear position indicator may be constructed by replacing the coded disc 22 with a pattern of coded channels. An example of such a pattern is shown in Figure 4, wherein the shaded portions 45 represent light-reflecting areas and the non-shaded portions represent areas of low reflectivity. Positional resolution for both the angle position and linear translation sensors is comparable to the core diameter of the fibre 20a through 20e, which may be between 2 and 8 mils (50 to 200 micro-meters). Greater positional accuracy may be obtained when the pattern stripes range from much larger than a fibre diameter to much smaller than a fibre diameter, as in Figure 4A. The fibre ends opposite the coded channels are unaltered for channels in which the stripe widths are equal to or greater than a fibre diameter, but where the stripes are smaller than the fibre diameter the end faces are altered by applying parallel opaque stripes with widths equal to the stripe width of the corresponding channel, as shown in the fibre end-face representations 52, 53, and 54 in Figure 4B. This permits the detection of motions that are comparable to the stripe width, rather than to the fibre diameter. Positional sensitivity with this dual striping is limited by how fine the striped patterns may be and still produce effective digital modulation of the reflected light signal. Diffraction theory indicates that the limiting stripe width is of the order of a wave length of light; thus, an accuracy of about one micro-meter (0.04 mils) is realizable.

All channels on the binary coded disc or linear stage pattern have alternate regions of high and low reflectivity. If the stripes on the fibre end faces are opaque and the stripes on the coded mask are reflecting, for any position the reflected signal is zero or 50 per cent of the incident light when the stripe widths are less than a fibre diameter, and zero or 100 per cent of the incident light when the stripe widths are equal to or greater than a fibre diameter. To provide equal reflected signal variations for all channels, the fibre end faces in channels wherein the stripe widths are equal to or greater than the fibre diameter may be striped with absorptive material perpendicular to the coding stripes of the channel. Acceptable striping patterns to provide substantially equal reflected signals are shown in the end-face representations 55 through 58 of Figure 4B.

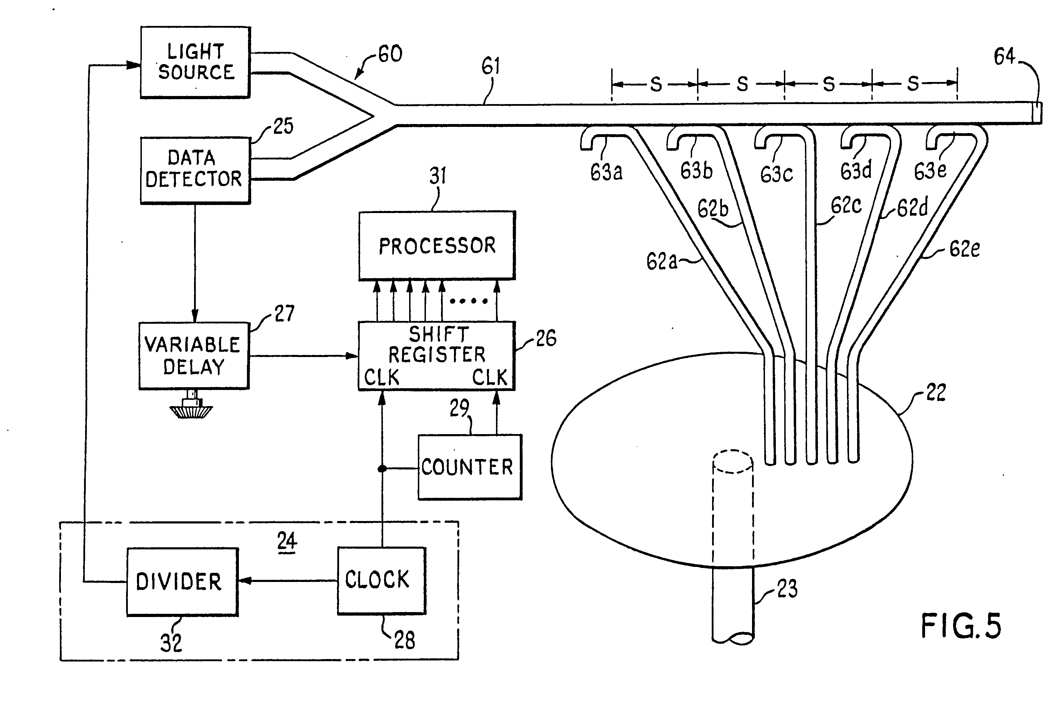

Figure 5 shows an alternative arrangement, in which the light source 12 is coupled by a "Y" coupler 60 to an optical transmission line 61 along which the inter-bit time delays previously described are obtained by coupling equal length optical fibres 62a through 62e to it by directional couplers 63a through 63e positioned along the optical transmission line 61 at equal spacings, "s". This system operates in the same way as the embodiment described with reference to Figure 1, the coded reflected optical pulse sequence being returned to the detector 25 via a "Y" coupler 60, and arriving at intervals substantially equal to 2s/V, where V is the velocity of light along the optical fibre 61. The optical fibre 61 is terminated with a non-reflecting device 64 to prevent residual light from being reflected to form an additional pulse in the coded pulse sequence.

-8-

## CLAIMS

1. An optical position sensor comprising a light source (12), light detecting means (25a) and an element (22) carrying channels coded with areas (22a, 22b) arranged to selectively complete or interrupt the light path between the source (12) and detecting means (25a), characterised in that the coded areas are either reflecting areas (22a) or non-reflecting areas (22b), the light source provides light pulses of short duration, the light path comprises an optical fibre system (15, 17, 18, 20a to 20e) branching from the light source towards the coded channels, the light paths along the various branches (20a to 20e) being of progressively increasing length, and light reflected back through the optical fibre system by the reflecting areas (22a) is delayed by different amounts to arrive at the detecting means (25a) as a sequence of pulses.

2. An optical position encoder according to claim 1 in which the optical fibre system comprises branch fibres (20a to 20e) of different lengths coupled to an optical transmission line (15) through a star coupler (19).

3. An optical position sensor according to claim 1 in which the optical fibre system comprises branch fibres (62a to 62e) coupled by couplers (63a to 63e) at spaced points along an optical transmission line (61).

4. An optical position sensor according to any preceding claim in which the detecting means (25) is coupled to the optic fibre system by reflecting means (14).

5. An optical position sensor according to any of claims 1, 2 or 3 in which the optical transmission line (16) includes a Y coupler (60) having the light source (12) coupled to one arm of the Y, and the detecting means (25) coupled to the other arm.

6. An optical position sensor according to any preceding claim in which the output from the light detecting means (25, 25a) is read serially into a shift register (26) which is cleared by means (29) between successive pulse sequences, and from which it is read in parallel into a data processor (31).

FIG.1

$\frac{2}{4}$

22b   22a

22a   22b

FIG. 2

DATA DETECTOR

SHIFT REGISTER   26

25

41

S
FLIP-FLOP
R

42

CLOCK

28

CLOCK

COUNTER   29

FIG. 3

FIG.4a

FIG.4b

FIG.5

0035885

Application number

EP 81 30 0943

**European Patent Office**

**EUROPEAN SEARCH REPORT**

| Category | Citation of document with indication, where appropriate, of relevant passages | Relevant to claim |
|---|---|---|
| **DOCUMENTS CONSIDERED TO BE RELEVANT** | | |
| X | GB - A - 1 540 907 (STANDARD TELEPHONES AND CABLES) <br> * Page 2, lines 46-65; figure 2; page 3, lines 11-16; figure 10 * | 1-5 |
| | FR - A - 2 128 699 (AUGUST SAUTER) <br> * Page 5, lines 19-35; figure 4 * | 6 |

**CLASSIFICATION OF THE APPLICATION (Int Cl.)**

H 03 K 13/18

**TECHNICAL FIELDS SEARCHED (Int. Cl.)**

H 03 K  13/18
G 01 D  5/249
        5/252
        5/32
        5/34
        5/26

**CATEGORY OF CITED DOCUMENTS**

X: particularly relevant

A: technological background

O: non-written disclosure

P: intermediate document

T: theory or principle underlying the invention

E: conflicting application

D: document cited in the application

L: citation for other reasons

&: member of the same patent family, corresponding document

The present search report has been drawn up for all claims

| Place of search | Date of completion of the search | Examiner |
|---|---|---|
| The Hague | 11-06-1981 | GUIVOL |

EPO Form 1503.1   06.78